(19)

Europäisches
Patentamt
European
Patent Office
Office européen
des brevets

(11)  **EP 1 876 710 B1**

(12)  **EUROPEAN PATENT SPECIFICATION**

(45) Date of publication and mention
of the grant of the patent:
**22.06.2011  Bulletin 2011/25**

(51) Int Cl.:
**H03K 17/082** $^{(2006.01)}$

(21) Application number: **06013946.6**

(22) Date of filing: **05.07.2006**

(54) **Circuit arrangement comprising a semiconductor switch, a current sensing circuit and a control circuit**

Schaltungsanordnung mit einem Halbleiterschalter, einer Stromdetektorschaltung und einer Steuerschaltung

Montage de circuit comprenant un commutateur à semi-conducteur, un circuit de détection de courant et un circuit de commande

(84) Designated Contracting States:
**DE FR GB IT**

(43) Date of publication of application:
**09.01.2008  Bulletin 2008/02**

(73) Proprietor: **Infineon Technologies AG**
**85579 Neubiberg (DE)**

(72) Inventors:
• **Solda, Silvia**
**35124 Padova (IT)**
• **Cortigiani, Fabrizio**
**35010 Busa di Vigonza (IT)**

• **Mignoli, Franco**
**37122 Verona (IT)**

(74) Representative: **Bickel, Michael**
**Westphal, Mussgnug & Partner**
**Patentanwälte**
**Herzog-Wilhelm-Strasse 26**
**80331 München (DE)**

(56) References cited:
| | |
|---|---|
| EP-A- 0 493 185 | EP-A- 0 639 894 |
| EP-A1- 1 229 234 | DE-B3- 10 256 057 |
| US-A- 5 408 141 | US-A- 5 576 615 |
| US-A1- 2004 246 043 | US-B1- 6 768 350 |

**Description**

The invention relates to a circuit arrangement comprising a semiconductor switch, a current measurement circuit for measuring the load-current through the semiconductor switch, and a control circuit, for limiting the current through the semiconductor switch.

For high current switches, an effective short circuit protection is indispensable due to very high current values occurring in the load path of the semiconductor switch. One solution to protect the device against short circuits of the load connected to the switch is to limit the load-current. This can be done by employing a feedback circuit which measures the load-current and controls the impedance of the semiconductor switch in order to limit the current to a maximum value. Temporary feedback of the load current of a semiconductor switch for limiting the slope of the load current ("etch shaping") is disclosed in EP 0 493 185. However, for current limiting other requirements halve to be met. EP 1 229 234 relates to a method of soft thermal shut down for power devices.

A critical value of the feedback circuit is the loop bandwidth of the feedback circuit, because the bandwidth determines the response time of the current limiting feedback circuit. However, a high bandwidth also has the adverse effect of causing stability problems and ripples. In low current applications the loop bandwidth of the feedback circuit can be kept low, thus avoiding stability and ripple problems, because, due to the higher resistance of the semiconductor switch, the current peak does not reach very high values even if the current limiting feedback circuit is not very fast. This is different for high current applications, when using low-resistance high current devices, where a fast reaction to an over-current is essential for protecting the device.

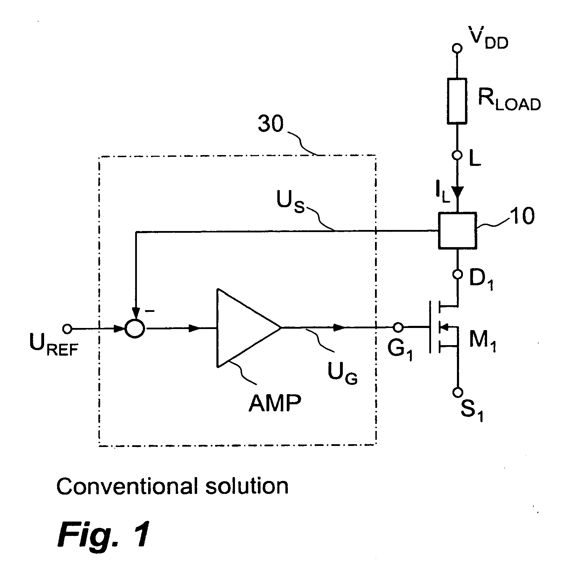

Generally the current limiting feedback circuit is designed as a proportional controller (p-controller), so the loop bandwidth is directly proportional to the open loop gain, i. e. the gain of the controller circuit. A conventional circuit arrangement comprising a semiconductor switch and a current limiting feedback circuit as described above is shown in figure 1. A load $Z_{LOAD}$ is connected between a first supply potential $V_{DD}$ and a first load terminal $D_1$ of a power-MOSFET $M_1$ serving as a low side semiconductor switch. A current measurement circuit 10 is connected to the power-MOSFET $M_1$ and provides a measurement signal $U_S$ which is proportional to the load-current $I_L$ through the power-MOSFET $M_1$. The measurement signal $U_S$ is subtracted from a reference signal $U_{REF}$ and the difference thereof is amplified by a p-controller AMP providing a control signal $U_G$ which is received by a gate terminal $G_1$ of the power-MOSFET $M_1$.

The reference signal $U_{REF}$ represents the maximum current value flowing through the load $Z_{LOAD}$. The subtracting means and the p-controller AMP form a control circuit 30. In case of a short circuit of the load $Z_{LOAD}$ an increasing current $I_L$ through the MOSFET $M_1$ would result in an increasing measurement signal $U_S$ and therefore a decreasing control signal $U_G$. A decreasing control signal $U_G$ causes a higher impedance of the power-MOSFET $M_1$ thus limiting the load-current $I_L$ to a value determined by a reference signal $U_{REF}$.

The speed of this controlling procedure depends on the gain of the p-controller AMP. If the gain of the controller is set too high, stability problems occur, so that the response time of the control circuit is limited by a stability bound given corresponding to a maximum allowable gain value. The contradicting objectives a circuit designer is confronted with are a stable (but slow) control circuit on the one side and a fast control circuit (showing stability problems) on the other side.

It is a problem of the current invention to provide a circuit arrangement comprising a semiconductor switch and a control circuit for said semiconductor switch which shows a short response time to an over current and avoids the stability problems.

This problem is solved by a circuit arrangement according to claim 1. Advantageous embodiments and enhancements are described in the dependent claims.

The concept behind the inventive solution is to dynamically adjust the loop gain of the feedback circuit controlling the semiconductor switch.

During normal operation, the semiconductor switch is operated in its linear region, i. e. in case of a power-MOSFET the region where an increasing drain-source-voltage is followed by an increasing drain-current. In that case the open loop lower frequency poles of the whole system are real and a high loop gain can then be applied without the system becoming instable. When, as a consequence of a current limitation due to a short circuit of a load, the power-MOSFET starts to operate in its saturation region, i. e. the region where the drain-current stays mainly constant although the drain-source-voltage is increasing. In that case, the two open loop lower frequency poles split and become complex and conjugate. The high loop gain then could move these two poles towards the imaginary axis, the system stability is reduced and a high ripple is visible in the time domain response of drain-current and drain-source-voltage.

To avoid system stability problems the loop gain is reduced by means of a second feedback from a first load terminal of a semiconductor switch. Due to this second feedback the loop gain can be reduced, when the semiconductor switch starts to operate in a saturation region due to a short circuit of the load and, as a result, both objectives, i. e. a high bandwidth and system stability, are achieved.

Besides a semiconductor switch with a first and a second load terminal and a control terminal the inventive circuit arrangement comprises a current-measurement circuit and a control circuit, wherein the current-measurement circuit is connected to the semiconductor switch and is adapted for sensing a load-current through the semiconductor switch. The current-measurement circuit provides a measurement signal representing the load-current through the semiconductor switch. The control circuit provides a control signal received by the control terminal of the semiconductor switch, wherein the control signal depends on the potential of the first load terminal of the semiconductor switch and of the measurement signal.

The control circuit typically comprises an adjustable gain amplifier comprising a first input terminal receiving the current-measurement signal, a second input terminal receiving a reference potential, an output terminal providing the control signal and a control terminal for adjusting the gain of the amplifier, The control terminal of the amplifier receives a signal being dependent on the potential of the first load terminal of the semiconductor switch.

The configuration described above mainly corresponds to the conventional solution shown in figure 1 with the difference that the gain of that amplifier is controlled by that potential of said first load terminal of that semiconductor switch. That control circuit may also comprise a filter receiving the potential of the first load terminal of the semiconductor switch and providing a filtered signal which controls the gain of the amplifier.

The filter typically is designed to provide as an output signal the first derivation of its input signal at least below a certain threshold frequency. Such a filter typically has a high-pass characteristic.

Preferably a power-MOSFET or an IGBT is used as semiconductor switch. In this case that first load terminal is a first drain terminal of the power-MOSFET, the second load terminal is a first source terminal of the power-MOSFET and the control terminal is a first gate terminal of the power-MOSFET.

The current measurement circuit typically comprises a sense-transistor comprising a second drain terminal, a second source terminal, and a second gate terminal, wherein the second drain terminal is connected to the first drain terminal of the power-MOSFET and the second gate terminal is connected to the first gate terminal of the power-MOSFET. A resistor is connected to that second source terminal of the sense-transistor. The measurement circuit above corresponds to a typical sense-FET arrangement, wherein the voltage drop over the resistor is proportional to the current through the power-MOSFET. This is true, if the power-MOSFET and the sense-transistor approximately have the same characteristic curves.

The following discussion explains the invention in more detail based on the figures.

Figure 1    shows a conventional current limiting circuit arrangement.

Figure 2    shows a circuit arrangement comprising a semiconductor switch, a current-measurement circuit, and a control circuit providing a control signal received by the control terminal of the semiconductor switch.

Figure 3    shows a circuit arrangement according to figure 2, wherein the control circuit comprises an adjustable gain amplifier and a filter.

Figure 4    shows a circuit arrangement according to figure 3, wherein the current-measurement circuit comprises a sense transistor and a resistor.

Figure 5    shows a circuit arrangement according to figure 4, wherein said filter is a RC-high-pass filter and the adjustable gain amplifier is build of two differential amplifiers.

Figure 6    shows a simplified AC block circuit of the circuit shown in figure 5.

In the figures, unless otherwise indicated, the same reference notations refer to the same components and the signals with the same meaning.

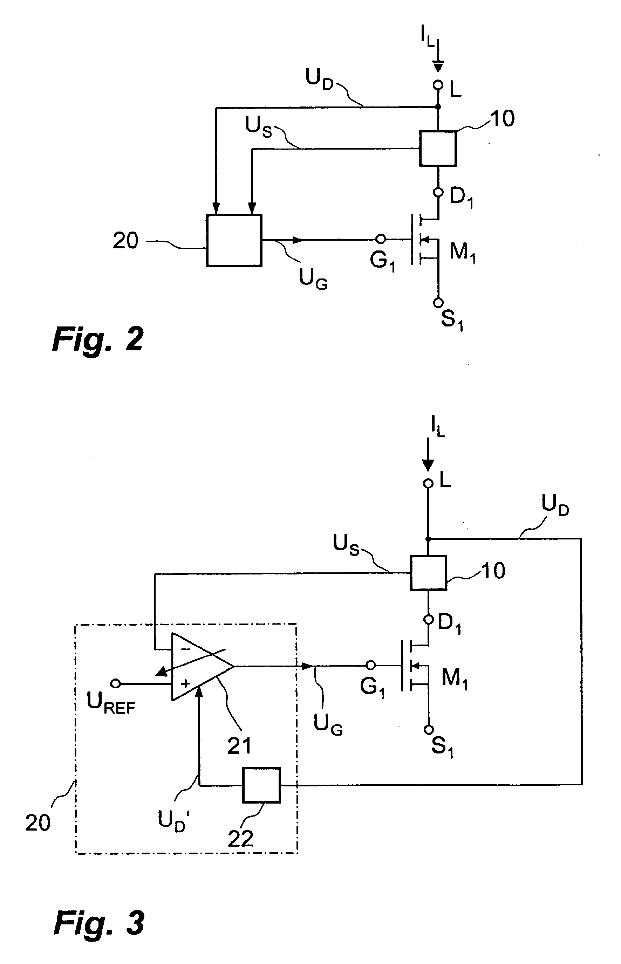

The circuit arrangement according to the current invention shown in figure 2 comprises a power-MOSFET $M_1$ which serves as semiconductor switch, a current measurement circuit 10 which measures the load-current through the power-MOSFET $M_1$ and a control circuit which provides a control signal $U_G$ received by the gate terminal $G_1$ of the power-MOSFET $M_1$. The input signals of the control circuit 20 are the measurement signal $U_S$ provided by the current measurement circuit 10 and a potential $U_D$ of the drain terminal $D_1$ of the power-MOSFET $M_1$ and, the measurement signal $U_S$ being substantially proportional to the load-current $I_L$ through the the power-MOSFET $M_1$. The drain terminal $D_1$ of the power-MOSFET $M_1$ is connected to a supply voltage via a load (both not shown). In case of a short circuit of the load, the feedback of the drain potential $U_D$ and the measurement signal $U_S$ both received by the control circuit 20 enables the control circuit 20 to provide a control signal $U_G$ such that the impedance of the power-MOSFET $M_1$ is increased and the load-current $I_L$ through the power-MOSFET $M_1$ is limited to a certain maximum value. The feedback of the drain potential $U_D$ guarantees a high bandwidth and still a stable operation of the closed loop control circuit.

In the embodiment shown in figure 3 the control circuit 20 is shown in more detail. It basically comprises an adjustable gain amplifier 21 with a first input terminal receiving the measurement signal $U_s$ from the current-measurement circuit 10 and a second input terminal receiving a reference signal $U_{REF}$ from an external signal source (not shown). The amplifier 21 further comprises an output terminal providing the control signal $U_G$ received by the gate terminal $G_1$ of the power-MOSFET $M_1$ and a control terminal receiving a filtered signal $U_{D'}$ which is a filtered version of the drain potential $U_D$.

The filter 22 operates as a differentiation filter which substantially provides the derivation of its input signal at least below a certain threshold frequency.

When the control circuit 20 starts to limit the load-current $I_L$ the drain potential $U_D$ also starts to increase, i. e. the signal $U_D$ exhibits a positive slope. The filtered signal $U_D'$ is the derivation of the drain potential $U_D$ and therefore proportional to its slope. A positive filtered signal $U_D'$ received by the control terminal of the adjustable gain amplifier 21 effects a reduction of the gain of the amplifier 21. In doing so, the gain of the amplifier 21 is reduced exactly in that state of operation where the power-MOSFET $M_1$ passes from its linear region to its saturation region. The reduction of the gain guarantees a stable operation during the current limiting process, whereas a high gain guarantees a short response time of the control circuit when the system is in its steadies state.

The differentiation filter 22 is typically designed as a high-pass filter which approximately operates as a differentiation filter below its cut of frequency.

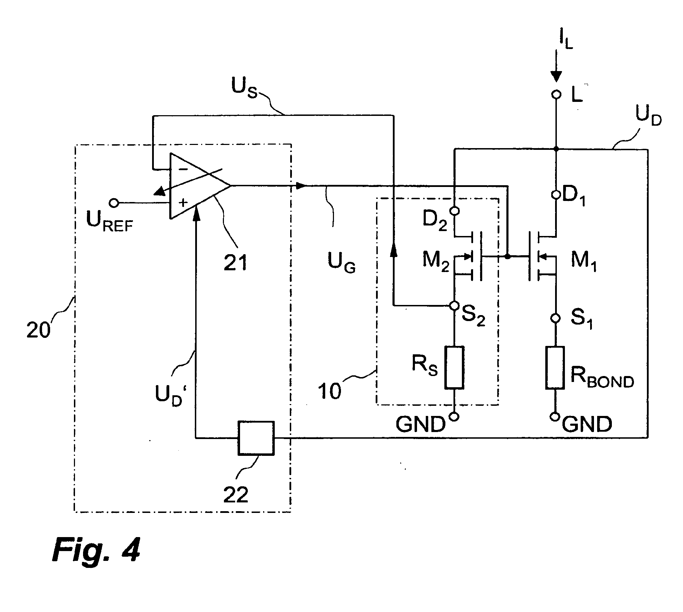

Figure 4 shows the measurement circuit 10 in more detail. The current-measurement circuit 10 comprises a resistor $R_s$ and a sense-transistor $M_2$ with a second drain terminal $D_2$, a second source terminal $S_2$ and a second gate terminal $G_2$. The resistor $R_S$ is connected to the second source terminal $S_2$, the second gate $G_2$ terminal is connected to the first gate terminal $G_1$ of the power-MOSFET $M_1$ and the second drain terminal $D_2$ is connected to the first drain terminal $D_1$ of the power-MOSFET $M_1$. This is the typical sense-transistor arrangement, where the voltage over the resistor $R_s$ is proportional to the load-current $I_L$ through the power-MOSFET $M_1$. Therefore, the sense-transistor $M_2$ and the power-MOSFET $M_1$ must have similar characteristic curves.

The source terminal $S_1$ of the power-MOSFET $M_1$ is connected to a ground potential GND via a bonding resistance $R_{BOND}$. The ratio of the bonding resistance $R_{BOND}$ and the resistor $R_S$ should be equivalent to the ratio $\beta_F$ of the drain-current through the sense-transistor $M_2$ and the load-current $I_L$ through the power-MOSFET $M_1$. This is important for the sense-FET $M_2$ and the power-MOSFET $M_1$ operating at the same operation point. The voltage drop over the resistor $R_S$ serves as measurement signal $U_S$ which is received by the amplifier 21 as in the previous embodiment shown in figure 3.

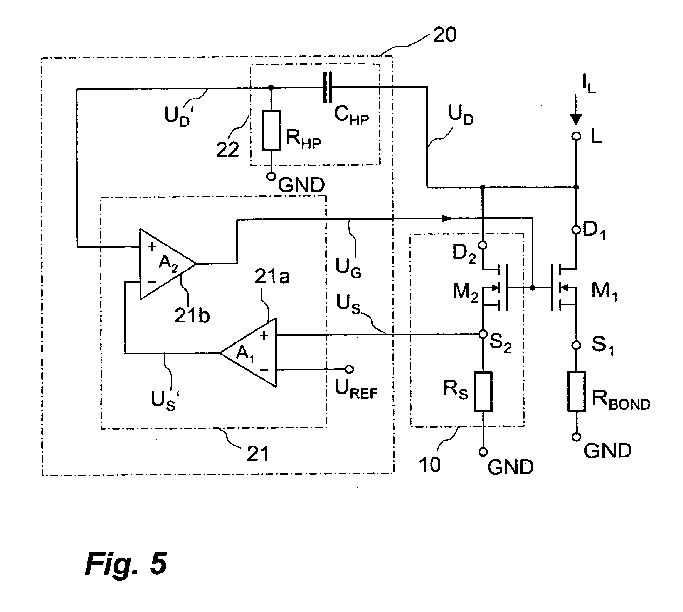

Figure 5 shows the control circuit 20 in more detail. In this embodiment the filter 22 is a passive RC-high-pass designed to operate as an differentiation filter. It comprises a capacitor $C_{HP}$ connected between the input terminal and the output terminal of the filter 22 and a resistor $R_{HP}$ connected between the output terminal of the filter and ground potential GND. The input terminal of the filter 22 receives the drain potential $U_D$ and provides a filtered signal $U_{D'}$ received by the adjustable gain amplifier 21. In this embodiment of the invention the adjustable gain amplifier comprises a first amplifying device 21A with a first input terminal receiving the measurement signal $U_S$ and the second input terminal receiving the reference signal $U_{REF}$ and an output terminal providing an amplified measurement signal $U_S'$. Further comprises a second amplifying device 21B with a first input terminal receiving the filtered signal $U_D'$ a second input terminal receiving the amplified measurement signal $U_S'$ and an output terminal providing a control signal $U_G$ which is received by the gate terminal $G_1$ of the power-MOSFET $M_1$. The first amplifying device has a gain $A_1$, the second amplifying device a gain $A_2$, so that in this configuration the control signal $U_G$ is given by the following equation:

$$U_G = -A_1 A_2 \left( U_S - U_{REF} \right) + A_2 U_D^{'} \qquad (1)$$

It can be seen from the equation above that an increasing load-current through the power-MOSFET $M_1$ (and therefore an increasing measurement signal $U_S$) results a decreasing control signal $U_G$ which increases the impedance of the power-MOSFET $M_1$. A simultaneously increasing drain potential $U_D$ (and therefore a positive derivate $U_D'$) counteracts the first effect and increases the control signal $U_G$, thus reducing the effective gain of the amplifier 21, i. e. the ratio $U_G/U_S$.

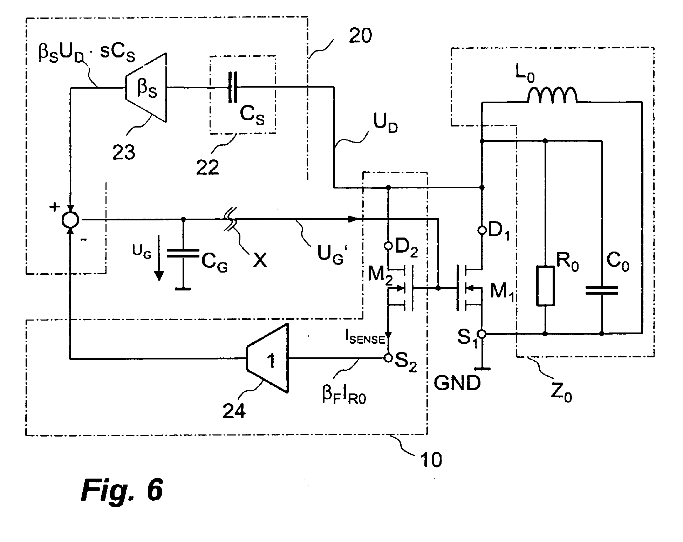

A model for the closed loop gain of the whole system can be derived from a simplified AC block circuit diagram as shown in figure 6. In this simplified model the current measurement circuit only comprises a unity gain current amplifier 24 amplifying the drain-source-current $I_{SENSE}$ (sense-current) of the sense-FET $M_2$ which is proportional to the channel-current $I_{R0}$ of the power-MOSFET $M_1$ and can be written as

$$I_{SENSE} = \beta_F I_{R0} \, . \qquad (2)$$

The channel of the power-MOSFET is modeled as a resistor $R_0$ and the sense-current $I_{SENSE}$ through the sense-FET is asumed to be exactly $\beta_F$ times the current throgh the channel-resistance $R_0$. The resistor $R_0$, the output-capacitance $C_0$ are connected between the drain terminal $D_1$ and the source terminal $S_1$ of the power-MOSFET. The load $Z_{LOAD}$ can be modeled as an inductance $L_0$ parallel to the drain-source path of the power-MOSFET $M_1$ in the case of a short circuit. The parallel circuit of the load inductance $L_0$, the cannel resistor $R_0$, and the output capacitance $C_0$ is denoted as complex load $Z_0$.

The control circuit 20 comprises a current amplifier 23 which is connected to the drain $D_1$ of the power-MOSFET via a capacitor $C_s$ which serves as a differentiating filter 22. The gain of the amplifier 23 is $\beta_s$ such that the output current $I_{23}$ of the amplifier 23 is given by

$$I_{23} = \beta_s s C_s U_D . \qquad (3)$$

The control circuit 20 further comprises a current-subtracting device receiving the output currents of the amplifiers 23 and 24 and provides a control current $I_G$ given by

$$I_G = \beta_s \cdot s C_s U_D - \beta_F I_{R0} . \qquad (4)$$

The control current $I_G$ charges the gate of the power-MOSFET $M_1$ having a gate-source-capacitance $C_G$. The voltage drop $U_G$ over the gate-source capacitance $C_G$ is then given by

$$U_G = \frac{1}{sC_G}\left(\beta_s \cdot s C_s U_D - \beta_F I_{R0}\right). \qquad (5)$$

The open loop transfer function OLTF of the whole system can be calculated by virtually breaking up the circuit at a position X marked in Figure 6. Denoting the voltage at the right side of the point X as gate voltage $U_G$' and at the left side as $U_G$ the open loop transfer function OLTF is given by the ration $U_G/U_G$'. Assuming a MOSFET transconductance $G_{mD}$ the drain potential $U_D$ of the power-MOSFET and the channel current $I_{R0}$ are given by

$$U_D = U_G' G_{mD} Z_0 . \qquad (6)$$

$$I_{R0} = U_G' G_{mD} \frac{Z_0}{R_0} . \qquad (7)$$

Substituting the equations (6) and (7) into equation (5) the open loop transfer function (OLTF) yields

$$OLTF = \frac{U_G}{U_G'} = G_{mD}\beta_s \frac{C_s}{C_0 C_G} \frac{\left(s - \frac{\beta_F}{\beta_s R_0 C_s}\right)}{s^2 + \frac{s}{R_0 C_0} + \frac{1}{L_0 C_0}} . \qquad (8)$$

This transfer function (8) has a zero point at $s = \beta_F/(\beta_s R_0 C_s)$ . With a properly designed filter 22, i. e. the capacitor $C_s$, the zero-point can be shifted such that the zero point is located at a lower frequency than the resonance freuquency of the open loop transfer function OLTF which is approximately $\sqrt{L_0 C_0}^{-}$ . If the condition

$$\frac{\beta_F}{\beta_S R_0 C_S} < \frac{1}{\sqrt{L_0 C_0}} \qquad (9)$$

is satified the phase margin of the open loop transfer function can increase up to 90° which guarantees the stability of the closed loop.

In other words, if the voltage drop $U_D$ over the power-MOSFET rises too sharply due to the current feedback in case of a short circuit of the load, the feedback of the derivation of the drain potential $U_D$ smoothes the sharp rise by increasing the gate voltage $U_G$ of the power-MOSFET for a short time.

List of Reference Notations

| | |
|---|---|
| $M_1$ | semiconductor switch (first transistor) |
| $D_1$ | first load terminal (first drain terminal) of $M_1$ |
| $S_1$ | second load terminal (first source terminal) of $M_1$ |
| $G_1$ | control terminal (first gate terminal) of $M_1$ |
| $M_2$ | sense-transistor |
| $D_1$ | second drain terminal of $M_2$ |
| $S_1$ | second source terminal of $M_2$ |
| $G_1$ | second gate terminal of $M_2$ |
| $R_s$ | sense-resistor |
| $Z_{LOAD}$ | load impedance |
| $R_0$ | channel resistance of $M_1$ |
| $C_0$ | output capacitance of $M_1$ |
| $L_0$ | inductive part of $Z_{LOAD}$ |
| $R_{HP}$, $C_{HP}$ | resistor and capacitor of filter 22 |
| $C_S$ | capacitor of filter 20 |

| | |
|---|---|
| I | load-current through $M_1$ |
| $I_{R0}$ | channel current (load-current) through $M_1$ |
| $I_{SENSE}$ | drain-current of sense-transistor $M_2$ |
| $\beta_F$ | ratio $I_{SENSE}/I_{R0}$ |
| $\beta_S$ | gain of 23 |
| $U_D$ | potential of said first load terminal $D_1$, drain potential |
| $U_D'$ | filtered signal of $U_D$ |
| $U_S$ | measurement signal |
| $U_G$ | control signal, gate voltage |
| $U_G'$ | control signal, gate voltage |
| $U_{REF}$ | reference potential |

| | |
|---|---|
| 10 | measurement circuit |
| 20 | control circuit |
| 21 | adjustable gain amplifier |
| 22 | (differentiating) filter |
| 23 | current amplifier (gain $\beta_S$) |
| 24 | current amplifier (unity gain) |

**Claims**

1. Current limiter comprising

- a semiconductor switch ($M_1$) having a first load terminal ($D_1$), a second load terminal ($S_1$) and a control terminal ($G_1$),
- a current measurement circuit (10) and

- a control circuit (20),

wherein

- said measurement circuit (10) is connected to said semiconductor switch ($M_1$) and is adapted for sensing a load-current ($I_L$) through said semiconductor switch providing a measurement signal ($U_s$) representing said load-current ($I_L$) and wherein

- said control circuit (20) receives a reference signal ($U_{REF}$) representing a maximum current provided by the semiconductor switch and provides a control signal ($U_G$) received by said control terminal ($G_1$) of said semiconductor switch ($M_1$), **characterized in that** said control signal ($U_G$) represents an amplified difference between the measurement signal ($U_S$) and the reference signal ($U_{REF}$), wherein the effective gain applied to said difference is dependent on the potential ($U_D$) of said first load terminal.

2. Current limiter according to claim 1, wherein said control circuit (20) comprises a filter (22) receiving said potential ($U_D$) of said first load terminal ($D_1$) of said semiconductor switch ($M_1$) and providing a filtered signal ($U_D$').

3. Current limiter according to claim 2, wherein said filter (22) is a differentiation filter providing as an output signal the derivation of its input signal at least in a given frequency range.

4. Current limiter according to claims 2 or 3, wherein said filter (22) is a high-pass filter.

5. Current limiter according to one of the previous claims, wherein said semiconductor switch ($M_1$) is a first transistor, said first load terminal ($D_1$) is a first drain terminal, said second load terminal ($S_1$) is a first source terminal, and said control terminal ($G_1$) is a first gate terminal.

6. Current limiter according to claim 5, wherein said measurement circuit (10) comprises

- a sense-transistor ($M_2$) comprising a second drain ($D_2$) terminal, a second source terminal ($S_2$) and a second gate terminal ($G_2$),

said second drain terminal ($D_2$) being connected to said first drain terminal ($D_1$) of said first transistor ($M_1$) and said second gate terminal ($G_2$) being connected to said first gate terminal ($G_1$) of said first transistor ($M_1$) ;

- a resistor ($R_S$) comprising a first terminal, said first terminal being connected to said second source terminal ($S_2$) of said sense-transistor ($M_2$),

wherein said voltage over said resistor ($R_S$) serves as said measurement signal ($U_S$).

7. A method for limiting current by a transistor ($M_1$), said transistor ($M_1$) having a first load terminal ($D_1$), a second load terminal ($S_1$) and a control terminal ($G_1$); the method comprising:

- sensing a load current ($I_L$) through the transistor and providing a measurement signal ($U_S$) representing the load current ($I_L$);

- providing a control signal to the control terminal ($G_1$) of the transistor ($M_1$) by a control circuit (20), said control circuit receiving a reference signal ($U_{REF}$) representing a maximum load current provided by the transistor, **characterized in that**

said control signal ($U_G$) represents an amplified difference between the measurement signal ($U_S$) and the reference signal ($U_{REF}$) , wherein the effective gain applied to said difference is dependent on the potential ($U_D$) of said first load terminal.

8. The method of claim 7 further comprising:

- filtering said potential ($U_D$) of said first load terminal of the transistor ($M_1$) and providing a filtered signal, wherein the effective gain applied to said difference is dependent on said filtered signal.

**Patentansprüche**

1. Strombegrenzer, umfassend:

- einen Halbleiterschalter ($M_1$) mit einem ersten Lastanschluss ($D_1$), einem zweiten Lastanschluss ($S_1$) und

einem Steueranschluss ($G_1$),
- eine Strommessschaltung (10) und
- eine Steuerschaltung (20),
wobei
- die Messschaltung (10) mit dem Halbleiterschalter ($M_1$) verbunden ist und dafür ausgelegt ist, einen Laststrom ($I_L$) durch den Halbleiterschalter zu erfassen, um ein Messsignal ($U_S$) zu liefern, das den Laststrom ($I_L$) repräsentiert, und wobei
- die Steuerschaltung (20) ein Referenzsignal ($U_{REF}$) empfängt, das einen maximalen durch den Halbleiterschalter gelieferten Strom repräsentiert, und ein Steuersignal ($U_G$) liefert, das durch den Steueranschluss ($G_1$) des Halbleiterschalters ($M_1$) empfangen wird, **dadurch gekennzeichnet, dass** das Steuersignal ($U_G$) eine verstärkte Differenz zwischen dem Messsignal ($U_S$) und dem Referenzsignal ($U_{REF}$) repräsentiert, wobei der auf die Differenz angewandte effektive Verstärkungsfaktor von dem Potential ($U_D$) des ersten Lastanschlusses abhängt.

2. Strombegrenzer nach Anspruch 1, wobei die Steuerschaltung (20) ein Filter (22) umfasst, das das Potential ($U_D$) des ersten Lastanschlusses ($D_1$) des Halbleiterschalters ($M_1$) empfängt und ein gefiltertes Signal ($U_D$') liefert.

3. Strombegrenzer nach Anspruch 2, wobei das Filter (22) ein Ableitungsfilter ist, das als Ausgangssignal die Ableitung seines Eingangssignals zumindest in einem gegebenen Frequenzbereich liefert.

4. Strombegrenzer nach Anspruch 2 oder 3, wobei das Filter (22) ein Hochpassfilter ist.

5. Strombegrenzer nach einem der vorhergehenden Ansprüche, wobei der Halbleiterschalter ($M_1$) ein erster Transistor ist, der erste Lastanschluss ($D_1$) ein erster Drainanschluss ist, der zweite Lastanschluss ($S_1$) ein erster Sourceanschluss ist und der Steueranschluss ($G_1$) ein erster Gateanschluss ist.

6. Strombegrenzer nach Anspruch 5, wobei die Messschaltung (10) Folgendes umfasst:

- einen Erfassungstransistor ($M_2$), der einen zweiten Drainanschluss ($D_2$), einen zweiten Sourceanschluss ($S_2$) und einen zweiten Gateanschluss ($G_2$) umfasst, wobei der zweite Drainanschluss ($D_2$) mit dem ersten Drainanschluss ($D_1$) des ersten Transistors ($M_1$) verbunden ist und der zweite Gateanschluss ($G_2$) mit dem ersten Gateanschluss ($G_1$) des ersten Transistors ($M_1$) verbunden ist;
- einen Widerstand ($R_S$) mit einem ersten Anschluss, wobei der erste Anschluss mit dem zweiten Sourceanschluss ($S_2$) des Erfassungstransistors ($M_2$) verbunden ist,

wobei die Spannung über dem Widerstand ($R_S$) als das Messsignal ($U_S$) dient.

7. Verfahren zum Begrenzen von Strom durch einen Transistor ($M_1$), wobei der Transistor ($M_1$) einen ersten Lastanschluss ($D_1$), einen zweiten Lastanschluss ($S_1$) und einen Steueranschluss ($G_1$) aufweist; wobei das Verfahren die folgenden Schritte umfasst:

- Erfassen eines Laststroms ($I_L$) durch den Transistor und Liefern eines Messsignals ($U_S$), das den Laststrom ($I_L$) repräsentiert;
- Leiten eines Steuersignals zu dem Steueranschluss ($G_1$) des Transistors ($M_1$) durch eine Steuerschaltung (20), wobei die Steuerschaltung ein Referenzsignal ($U_{REF}$) empfängt, das einen maximalen durch den Transistor gelieferten Laststrom repräsentiert, **dadurch gekennzeichnet, dass**

das Steuersignal ($U_G$) eine verstärkte Differenz zwischen dem Messsignal ($U_S$) und Referenzsignal ($U_{REF}$) repräsentiert, wobei der auf die Differenz angewandte effektive Verstärkungsfaktor von dem Potential ($U_D$) des ersten Lastanschlusses abhängt.

8. Verfahren nach Anspruch 7, ferner mit den folgenden Schritten:

- Filtern des Potentials ($U_D$) des ersten Lastanschlusses des Transistors ($M_1$) und Bereitstellen eines gefilterten Signals, wobei der auf die Differenz angewandte effektive Verstärkungsfaktor von dem gefilterten Signal abhängt.

**Revendications**

1. Limiteur de courant, comprenant

   - un commutateur ($M_1$) à semiconducteur ayant une première borne ($D_1$) de charge et une deuxième borne ($S_1$) de charge et une borne ($G_1$) de commande,
   - un circuit (10) de mesure du courant et
   - un circuit (20) de commande,
   dans lequel
   - le circuit (10) de mesure est connecté au commutateur ($M_1$) à semiconducteur et conçu pour détecter un courant ($I_L$) de charge passant dans le commutateur à semiconducteur en fournissant un signal ($U_S$) de mesure représentant ce courant (IL) de charge et dans lequel
   - le circuit (20) de commande reçoit un signal ($U_{REF}$) de référence représentant un courant maximum fourni par le commutateur à semiconducteur et fournit un signal ($U_G$) de commande reçu par la borne ($G_1$) de commande du commutateur ($M_1$) à semiconducteur, **caractérisé en ce que**

   le signal ($U_G$) de commande représente une différence amplifiée entre le signal ($U_S$) de mesure et le signal ($U_{REF}$) de référence, le gain efficace appliqué à la différence dépendant du potentiel ($U_D$) de la première borne de charge.

2. Limiteur de courant suivant la revendication 1, dans lequel le circuit (20) de commande comprend un filtre (22) recevant le potentiel ($U_D$) de la première borne ($D_1$) de charge du commutateur ($M_1$) à semiconducteur et fournissant un signal ($U_D$') filtré.

3. Limiteur de courant suivant la revendication 2, dans lequel le filtre (22) est un filtre de différenciation fournissant comme signal de sortie la dérivée de son signal d'entrée, au moins dans une plage de fréquence donnée.

4. Limiteur de courant suivant la revendication 2 ou 3, dans lequel le filtre (22) est un filtre passe-haut.

5. Limiteur de courant suivant l'une des revendications précédentes, dans lequel le commutateur ($M_1$) à semiconducteur est un premier transistor, la première borne ($D_1$) de charge est une première borne de drain, la deuxième borne ($S_1$) de charge est une première borne de source et la borne ($G_1$) de commande est une première borne de grille.

6. Limiteur de courant suivant la revendication 5, dans lequel le circuit (10) de mesure comprend

   - un transistor ($M_2$) de détection, comprenant une deuxième borne ($D_2$) de drain, une deuxième borne ($S_2$) de source et une deuxième borne ($G_2$) de grille,
   la deuxième borne ($D_2$) de drain étant connectée à la première borne ($D_1$) de drain du premier transistor ($M_1$) et la deuxième borne ($G_2$) de grille étant connectée à la première borne ($G_1$) de grille du premier transistor ($M_1$) ;
   - une résistance ($R_S$) comprenant une première borne, la première borne étant connectée à la deuxième borne ($S_2$) de source du transistor ($M_2$) de détection,

   dans lequel la tension aux bornes de la résistance ($R_S$) sert de signal ($U_S$) de mesure.

7. Procédé de limitation du courant par un transistor ($M_1$) , le transistor ($M_1$) ayant une première borne ($D_1$) de charge, une deuxième borne ($S_1$) de charge et une borne ($G_1$) de commande ; procédé dans lequel :

   - on détecte un courant ($I_L$) de charge passant dans le transistor et on fournit un signal ($U_S$) de mesure représentant le courant ($I_L$) de charge ;
   - on fournit un signal de commande à la borne ($G_1$) de commande du transistor ($M_1$) par un circuit (20) de commande, le circuit de commande recevant un signal ($U_{REF}$) de référence représentant un courant de charge maximum fourni par le transistor, **caractérisé en ce que**

   le signal ($U_G$) de commande représente une différence amplifiée entre le signal ($U_S$) de mesure et le signal ($U_{REF}$) de référence, le gain efficace appliqué à la différence dépendant du potentiel ($U_D$) de la première borne de charge.

8. Procédé suivant la revendication 7, dans lequel, en outre :

   - on filtre le potentiel ($U_D$) de la première borne de charge du transistor ($M_1$) et on fournit un signal filtré, dans lequel le gain efficace appliqué à la différence dépend du signal filtré.

Conventional solution

*Fig. 1*

**Fig. 2**

**Fig. 3**

**Fig. 4**

**Fig. 5**

*Fig. 6*

**REFERENCES CITED IN THE DESCRIPTION**

**Patent documents cited in the description**

- EP 0493185 A
- EP 1229234 A